# FASCICULE DE BREVET EUROPEEN

(11) **EP 2 672 320 B1**
(45) Date de publication et mention de la délivrance du brevet: **28.09.2016**
(21) Numéro de dépôt: 13170573.3
(22) Date de dépôt: 05.06.2013
(51) Int. Cl.: G03F 7/00, C25D 1/16, C25D 1/00, B29C 33/00

(54) **Procédé de fabrication de micro-pièces métalliques tridimensionnelles par croissance dans une cavité mixte et micro-pièces obtenues par le procédé**
Herstellungsverfahren von dreidimensionalen Metallmikroteilen durch Wachstum in einem gemischten Hohlraum, und durch dieses Verfahren erhaltene Mikroteile
Method for producing three-dimensional metal micro-parts by growth in a mixed cavity and micro-parts obtained by the method

(30) Priorité: 06.06.2012 EP 12170996
(43) Date de publication de la demande: 11.12.2013
(73) Titulaire: Mimotec S.A., 1950 Sion (CH)
(72) Inventeur: Lorenz, Hubert, 1965 Savièse (CH); Genolet, Grégoire, 1926 Fully (CH); Glassey, Marc-André, 1967 Bramois (CH)
(74) Mandataire: Leman Consulting S.A.

(56) Documents cités:
- EP-A1- 2 261 171
- EP-A2- 0 607 680
- CH-A2- 704 086
- US-A- 5 234 571
- FAHRENBERG J ET AL: "High aspect ratio multi-level mold inserts fabricated by mechanical micro machining and deep etch X-ray lithography", MICROSYSTEM TECHNOLOGIES, BERLIN, DE, vol. 2, no. 1, 1 mars 1995 (1995-03-01), pages 174-177, XP002607734, ISSN: 0946-7076, DOI: 10.1007/BF02739554

## Description

### Domaine de l'invention

La présente invention concerne le domaine de la fabrication de micro-pièces métalliques tridimensionnelles par électroformage en particulier des pièces présentant au moins deux parties ayant chacune une forme prédéfinie. Certaines pièces utilisées notamment dans l'horlogerie comme par exemple des vis, des sautoirs ,des ressorts avec talon, des appliques ou des roues avec pied, des pièces plates avec une base oblique, des pieds-vis, etc., sont également des objets de l'invention ainsi que le procédé permettant de les réaliser avantageusement.

### Arrière plan technique

Le procédé de fabrication de micro-pièces ou composants par irradiation d'une couche photosensible aux rayons ultraviolets suivie d'une étape d'électroformage est connu et est décrit par exemple dans le brevet EP0851295B1.

Ce procédé est dérivé de la technique LIGA (Lithographie Galvanoformung Abformung) qui consiste à:
- déposer sur un substrat une couche de 1 à 2000 µm d'une résine photosensible (photorésist);
- effectuer à travers un masque une irradiation au moyen d'un synchrotron ou par une exposition de rayons ultraviolets;
- développer, c'est-à-dire éliminer par des moyens chimiques les portions de photorésist non polymérisées et créer de ce fait une cavité ou un moule en photorésist.
- électroformer un métal dans cette cavité afin d'obtenir une micro-pièce métallique.

L'avantage de cette technique est de réaliser des pièces ou composants mécaniques d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit plus avant dans la demande de brevet EP1225477A1 et détaille le processus de masquage, d'irradiation et de dissolution de la partie non irradiée. Cette technique est bien connue pour la fabrication de pièces pour l'horlogerie tels que par exemple des roues dentées, des cames, bascules ou ponts.

Plusieurs techniques de fabrication de pièces multi-niveaux basées sur le procédé LIGA sont décrites dans des documents de l'art antérieur à savoir :
EP2157476A1, ce document décrit un procédé de fabrication de pièces métalliques multi niveaux par la technologie UV-LIGA. Chaque couche de photorésist formant les niveaux de la pièce est creusée d'ouvertures formant un moule dans lequel est déposé par électroformage une couche métallique. Les pièces obtenues sont composées de niveaux formés dans un seul métal ou dans plusieurs métaux différents. Les différents niveaux de la cavité ne sont formés que dans des couches de photorésist superposées.
EP1835339A1, ce document décrit un procédé analogue à celui du document EP2157476A1 en utilisant un substrat métallique massif. Des étapes d'usinage intermédiaire de la pièce électroformée dans un moule de photorésist complètent ce procédé. Les différents niveaux du moule sont également formés dans une ou plusieurs couches de photorésist comme dans le document précédent.
EP2405301A1, selon des variantes du procédé, la cavité comporte un ou plusieurs étages obtenus par gravure profonde d'un substrat en silicium en utilisant le procédé DRIE (Deep Reactive Ion Etching) par exemple et des étages formés par un moule en photorésist. Les étages formés dans le substrat ne comportent que des flancs verticaux et lisses où un effet de champignonnage ne se présente pas.
US5234571A qui décrit un procédé de fabrication de garnitures de moulage étagées servant à mouler des pièces à microstructures étagées. Le procédé comprend des étapes de :
   - dépôt sur une plaque de base conductrice d'une couche isolante d'épaisseur correspondant à la hauteur d'un étage de la garniture de moulage,
   - dépôt sur la couche isolante d'une couche conductrice d'épaisseur inférieure à celle de la couche isolante,
   - usinage des couches déposées sur la plaque de base de manière à enlever de la matière et former des cavités jusqu'à atteindre la plaque de base,
   - remplissage des cavités et recouvrement de la plaque avec une couche de photorésist,
   - irradiation de la couche de photorésist à travers un photomasque, élimination de la couche de photorésist non polymérisée et libération de la couche conductrice et de la plaque de base,
   - dépôt galvanique de métal dans les cavités et recouvrement de toutes les cavités par une couche de métal de plusieurs millimètres,
   - enlèvement de la plaque de base, et dissolution des parties restantes des couches isolante et conductrice et obtention d'une garniture de moulage métallique. EP0607680A2 qui décrit un procédé de fabrication de microstructures utilisant une feuille de photorésist préformée. Le procédé comprend des étapes de :
   - dépôt d'une couche conductrice sur un substrat isolant servant de base de placage,
   - adhésion d'une feuille de photorésist préformée par photolithographie, l'épaisseur de la feuille ayant été réduite par usinage avant le développement de la feuille,
   - dépôt galvanique d'une couche métallique dans des zones de la feuille de photorésist dans lesquelles le photorésist a été éliminé,
   - élimination du photorésist restant pour obtenir des microstructures métalliques plaquées sur le substrat
XP002607734, Fahrenberg J et al. « High aspect ratio multi-level mold inserts fabricated by mechanical micro machining and deep etch X-ray lithography » qui décrit un procédé de fabrication par usinage de précision et lithographie à rayons X de micro-moules et de microstructures multi-niveaux à flancs verticaux
CH704086A2 qui décrit une méthode de fabrication de micro-pièces métalliques tridimensionnelles comportant au moins un assemblage de deux éléments obtenus par photolithographie et électroformage formant respectivement un premier et un second niveau de la pièce. Un second élément de ces micro-pièces est imbriqué et solidaire d'un premier élément rapporté positionné dans un moule obtenu par des procédés dérivés de la photolithographie. Ce second élément formant le second niveau constitué par une couche métallique est ainsi intimement lié à l'élément rapporté formant le premier niveau soit par au moins un orifice traversant formé dans l'élément rapporté, soit par enrobage de la couche métallique d'au moins une portion du contour de l'élément rapporté. De plus, le second niveau s'étend partiellement ou entièrement sur le premier niveau et sur une zone extérieure au voisinage dudit premier niveau. Les deux niveaux pouvant être constitués par des métaux identiques ou différents..

Certaines pièces micromécaniques complexes sont très ardues à fabriquer par les moyens traditionnels. Une vis doit par exemple subir de nombreuses opérations d'usinage qui rendent son obtention compliquée en raison des tailles en présence. De plus toutes ces opérations se réalisent de manière sérielle et non pas simultanément en lots ce qui permettrait de gagner en temps et en efficacité. Le procédé décrit ci-dessous permet de pallier ces inconvénients par la fabrication de micro-pièces en combinant des opérations d'usinage mécaniques simples, des opérations photolithographiques, des opérations d'électroformage et des usinages mécaniques finaux. Un avantage de ce procédé est de permettre un usinage de pièces en métal précieux sans produire de déchets, en particulier des pièces en or électroformé.

### Description sommaire de l'invention

Le but de la présente invention est de fabriquer avec une grande précision des micro-pièces mécaniques métalliques tridimensionnelles comportant deux ou plusieurs parties superposées qui ne peuvent pas être toutes fabriquées par des procédés conventionnels ou utilisant la technologie UV-LIGA.

Ce but est atteint par un procédé de fabrication de micro-pièces métalliques comportant au moins deux parties décrit par la revendication 1.

Le procédé permet ainsi de produire plusieurs micro-pièces à la fois c'est-à-dire par lots (batch processing) sur un même support. Les cavités traversantes de la plaque sont usinées en effectuant des opérations relativement simples comme par exemple, le taraudage, le fraisage, l'étampage, le perçage etc., mais difficiles à réaliser par un procédé photolithographique. Dans le cas d'une plaque en silicium, l'usinage des cavités est réalisé par DRIE (Deep Reactive Ion Etching), l'usinage mécanique du silicium étant particulièrement délicat, voire impossible.

Il est à noter que le procédé de la présente invention est limité au type de photorésist négatif. Dans le cas d'un photoresist positif, par exemple Shipley S1818 ou TOK C-1000, le photomasque est configuré de manière à irradier et dépolymériser des zones de la couche de photorésist déposée destinées à être éliminées, les zones non irradiées c'est-à-dire polymérisées étant conservées.

Dans le cas d'un photorésist négatif, par exemple du type SU-8, le photomasque a une configuration inverse par rapport à celui qui est utilisé pour le photorésist positif, les zones de la couche de photorésist déposée destinées à être conservées sont irradiées et polymérisées et les zones non irradiées c'est-à-dire non polymérisées étant éliminées.

La description du procédé ci-après utilise un photorésist négatif qui permet de réaliser des couches aptes à être photolithographiées plus épaisses que celles réalisées avec un photorésist positif.

Le procédé photolithographique est utilisé pour les parties des micro-pièces comportant un contour complexe pour la réalisation duquel des opérations d'usinage classiques deviennent difficiles, voire impossibles surtout pour une production par lots. De plus, l'utilisation de la plaque permet d'atteindre une profondeur des cavités plus élevée (quelques millimètres) que celle réalisable par une couche de photorésist.

Ce procédé de fabrication exploite le phénomène de champignonnage et de croissance du métal conforme le long des parois des cavités usinées dans la plaque. Pour que ce phénomène puisse se présenter, il est nécessaire d'isoler les parois des cavités usinées dans une plaque métallique.

Les procédés décrits par les documents, US5234571A, EP0607680A2, XP002607734, Fahrenberg J et al. et CH704086A2 bien que permettant d'obtenir des cavités multi-niveaux mixtes à parois internes verticales, ne permettent pas d'obtenir des cavités multi-niveaux mixtes dont au moins un niveau comporte une paroi interne structurée, c'est-à-dire une paroi comprenant un filetage ou une combinaison d'au moins un palier horizontal avec un filetage ou une combinaison d'au moins un flanc vertical ou oblique avec un filetage.

Selon la structure des parois des cavités, les surfaces horizontales peuvent être rendues conductrices si les cavités sont formées dans un matériau isolant et les parois internes comportant des paliers verticaux et/ou obliques peuvent être rendues isolantes si les cavités sont formées dans un matériau conducteur.

### Brève description des figures

L'invention sera mieux comprise grâce à la description détaillée qui va suivre en se référant aux dessins annexés dans lesquels :
La figure 1 montre les étapes essentielles du procédé selon l'invention en utilisant une plaque usinée en matière isolante sur laquelle est déposée une couche de photorésist. Les cavités mixtes sont formées par un niveau usiné dans la plaque isolante et par un niveau formé dans la couche en photorésist.
La figure 2 montre une variante du procédé avec des cavités mixtes comportant quatre niveaux dont deux sont usinés dans une plaque en matière isolante. La pièce résultante est ainsi formée de trois parties.
La figure 3 illustre un exemple de cavité mixte multi-niveaux dont deux niveaux sont usinés dans deux plaques conductrices superposées et trois niveaux formés dans des couches successives de photorésist.
La figure 4 illustre un autre exemple de cavité mixte multi-niveaux avec des niveaux formés alternativement par des plaques usinées en matière isolante et par des couches de photorésist, le support conducteur étant également usiné. La pièce résultante est ainsi formée de cinq parties.

### Description détaillée de l'invention

Les micro-pièces métalliques sont obtenues par électroformage dans une pluralité de cavités mixtes comprenant au moins deux niveaux positionnés l'un au-dessus de l'autre. Un des niveaux des cavités est réalisé par usinage dans une plaque de matière isolante ou conductrice. L'autre niveau des cavités est formé par photolithographie.

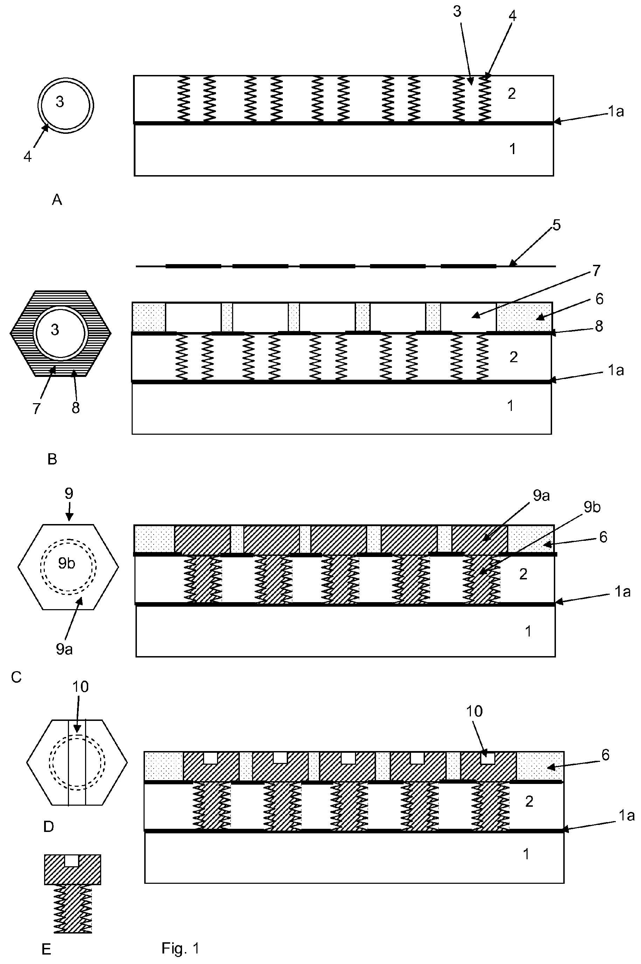

Dans l'exemple de la figure 1 représentant schématiquement la fabrication de vis, le premier niveau des cavités réalise la tige filetée des vis tandis que le second niveau réalise la tête. Le second niveau est ici disposé dans l'axe du premier niveau. Les parois internes du niveau des cavités formant les tiges filetées sont structurées par une combinaison de paliers obliques disposée verticalement sur toute l'épaisseur de la plaque et obtenues par taraudage de cette dernière. Lors de l'étape A, une plaque (2) comportant une pluralité de trous filetés traversants est assemblée sur un support (1) conducteur ou isolant pourvu d'une couche conductrice (1a) déposée par métallisation (chrome, nickel, or ou autres métaux). Le support (1) peut être également constitué de silicium revêtu d'une couche conductrice.

Le premier niveau des cavités (3) est ainsi constitué par les trous filetés fermés par le support (1) conducteur ou rendu conducteur par la couche conductrice (1a) sur lequel est posé la plaque (2) constituant le fond de chaque cavité (3).

Etant donné que l'usinage de la plaque (2) ne peut pas être réalisé par un procédé photolithographique, il est effectué par des moyens conventionnels avec une grande précision par perçage et taraudage d'une pluralité de trous traversants.

L'étape B consiste à déposer sur la plaque (2) une couche de photorésist (6) sensible aux rayons ultraviolets (UV) (ou aux rayons X selon la technologie choisie). La couche de photorésist se compose soit d'une résine liquide étalée en une couche d'épaisseur uniforme sur la plaque (2), soit d'une feuille ou d'une plaque de résine superposée et laminée à chaud sur la plaque (2). Les feuilles ou plaques de résine permettent de former une couche de photorésist sans devoir remplir les cavités précédemment formées et d'éviter une longue étape de séchage.

La couche de photorésist (6) est ensuite irradiée par une source à ultraviolets ou à rayons X à travers une plaque en verre sur laquelle ont été structurés des motifs en chrome ou en or. Cette plaque avec ses découpes de chrome ou d'or est appelée un photomasque (5). La lumière arrivant parfaitement perpendiculairement sur le photomasque (5), seules les portions de photorésist non protégées par les motifs en chrome ou en or seront irradiées. Les flancs des portions de photorésist sont ainsi perpendiculaires à la plaque (2). Dans le cas particulier d'une résine négative comme par exemple le SU8 ou ses dérivés, un recuit de la couche de photorésist (6) provoque la polymérisation dans les zones ayant reçu le rayonnement UV. Cette partie polymérisée devient insoluble dans la plupart des solvants par opposition aux zones non irradiées qui seront dissoutes par un solvant. Le photomasque (5) est positionné en masquant complètement chaque cavité (3) et au moins une zone de la couche de photorésist (6) connexe à chaque cavité (3). En d'autres termes, le photomasque (5) est placé de sorte que les motifs du photomasque (5) couvrent entièrement les cavités (3) usinées de la plaque (2) et au moins une zone dans le voisinage de chaque cavité (3) en contact avec celle-ci. Dans l'exemple de la figure 1, le photomasque (5) comportant des motifs hexagonaux est disposé de sorte que ces motifs soient centrés au-dessus des trous filetés de la plaque de manière coaxiale à ceux-ci et au-dessus d'une zone de la couche de photorésist (6) entourant chaque trou fileté.

Après élimination des portions non polymérisées de la couche de photorésist (6), chaque cavité (3) usinée est complétée par une cavité (7) traversante ou moule en photorésist formant un second niveau. Les cavités finales ainsi obtenues forment des cavités mixtes avec un premier niveau usiné et un second niveau obtenu par photolithographie.

Dans le cas d'une plaque (2) en matière isolante comme dans l'exemple de la figure 1, une étape supplémentaire de dépôt d'une couche conductrice (8) sur la surface de la plaque (2) peut être effectuée avant le dépôt de la couche de photorésist (6). Le fond du second niveau des cavités traversantes (7) est ainsi constitué par cette couche conductrice (8) servant à faciliter la croissance de la couche métallique (9a, 9b) commencée au fond des cavités usinées de la plaque (2).

Dans le cas d'une plaque (2) métallique, une étape supplémentaire de dépôt d'une couche isolante sur les parois internes des cavités (3) usinées (filetées) est effectuée avant le dépôt de la couche de photorésist (6). Cette isolation assure une croissance régulière de la couche métallique (9a, 9b) depuis le fond des cavités (3) constitué par le support métallique ou métallisé (1) et continuant depuis la face supérieure métallique de la plaque (2).

A l'étape C une couche métallique (9a, 9b) est déposée par électroformage dans la cavité mixte (3, 7). Le métal croît depuis le fond du premier niveau des cavités mixtes constituées par le support (1) pour remplir ce premier niveau et le sillon isolé du filetage par effet de champignonnage ou de débordement. La croissance continue dans le second niveau en photorésist à partir du palier formé par la couche conductrice (8) de la face supérieure de la plaque (2) jusqu'au bord supérieur du moule en photorésist. La couche métallique remplit ainsi entièrement les cavités mixtes pour former un lot de pièces métalliques (vis) sur la plaque (2). La surface de la couche métallique est ensuite usinée par un procédé mécanique pour lui donner une épaisseur prédéfinie (étape D). Des opérations supplémentaires de finition telles que des fraisages, perçages, gravures peuvent également être effectuées sur les micro-pièces dans leur cavité mixte comme dans l'exemple de la figure 1, où des fentes sont fraisées sur la tête des vis.

Le moule en photorésist polymérisé est éliminé par attaque chimique et les micro-pièces (9) sont extraites de la plaque (2), (étape E). Un lot d'une pluralité de micro-pièces (9) est ainsi obtenu dont chaque micro-pièce (9) comporte deux parties superposées (9a, 9b) formées par les niveaux des cavités mixtes (3, 7) correspondant respectivement à la tige filetée et à la tête des vis de l'exemple. Dans le cas où l'extraction de la pièce ne détruit pas la plaque ou le support, ils peuvent être réutilisés.

Selon une variante du procédé, les étapes A et B peuvent être inversées c'est-à-dire que :
- Lors d'une étape B' une couche de photorésist (6a) est déposée sur le support conducteur (1), puis irradiée et polymérisée au moyen d'un photomasque (5), la couche de photorésist (6a) non polymérisée est éliminée et la couche de photorésist restante forme une pluralité de cavités (7a) traversantes.
- Lors d'une étape A', la plaque (2) en matière isolante ou conductrice comprenant une pluralité de cavités (3) traversantes usinées à parois structurées est assemblée sur le support conducteur (1) recouvert par la couche de photorésist (6a) de manière à obtenir une pluralité de cavités mixtes (7a, 3). Celles-ci comportent chacune un premier niveau formé par une cavité (7a) dans la couche de photorésist (6a) et un second niveau formé par une cavité (3) de la plaque (2) positionnée en aplomb du premier niveau.

Les étapes C, D, et E restent inchangées.

Le procédé de l'invention s'applique également pour la production de pièces comportant plus que deux parties superposées utilisant des cavités mixtes comportant plus que deux niveaux. Les niveaux des cavités peuvent être superposés dans un ordre quelconque c'est-à-dire que le ou les niveaux formés par des plaques et le ou les niveaux formés par des moules en photorésist peuvent se succéder de façon quelconque en fonction du profil et de la forme des pièces à fabriquer. Les micro-pièces obtenues comportent ainsi un nombre de parties correspondant au nombre de niveaux des cavités mixtes.

Les parties métalliques de la pièce sont constituées de préférence par un métal tel que de l'or, le nickel (Ni), le cuivre (Cu), le fer (Fe) ou un alliage basé sur un de ces métaux comme par exemple le nickel - phosphore (NiP).

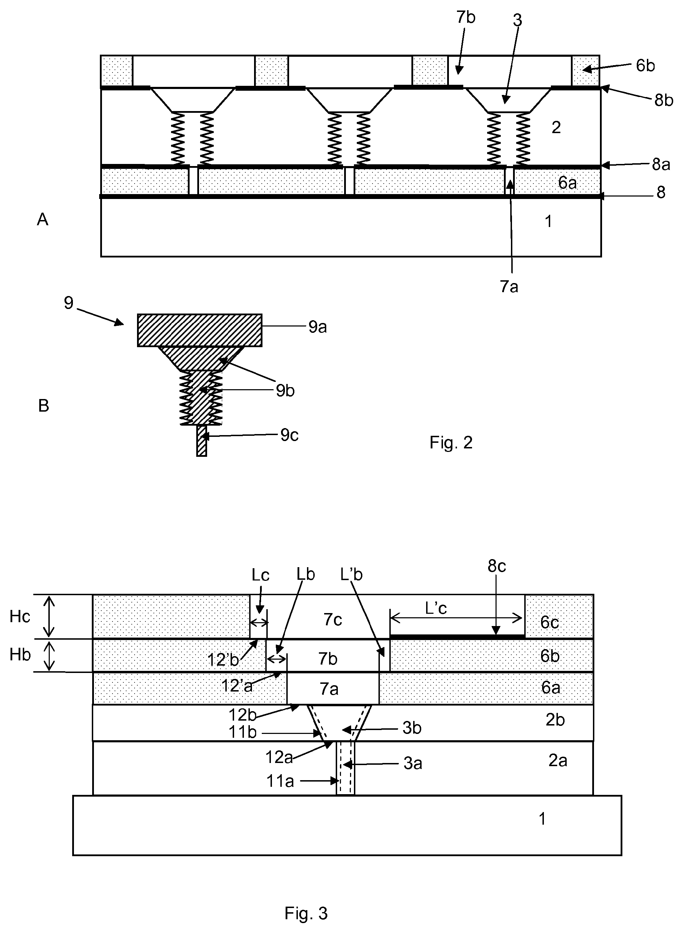

La figure 2A montre un exemple de cavités mixtes multi-niveaux comprenant des cavités (7a) d'un premier niveau formées par photolithographie dans une couche de photorésist (6a) appliquée sur la couche conductrice (8) du support (1). Cette première couche de photorésist (6a) est recouverte par une couche conductrice (8a) pour former une base à des cavités (3) traversantes d'un second niveau obtenues par usinage d'une plaque (2) en matière isolante. Après un dépôt d'une seconde couche conductrice (8b) sur la plaque (2), une troisième couche de photorésist (6b) est appliquée dans laquelle des cavités (7b) d'un troisième niveau sont formées par photolithographie. Les niveaux des cavités mixtes ainsi formées sont disposés en aplomb les uns au dessus des autres pour assurer une croissance continue de la couche métallique (9) à partir du fond d'une cavité (7a) du premier niveau jusqu'au sommet d'une cavité (7b) dans la couche de photorésist (6b) du troisième et dernier niveau.

La couche métallique (9) commence sa croissance sur la couche conductrice (8) déposée sur le support (1) dans le premier niveau (7a) puis continue dans le niveau défini par la plaque (2) usinée pour terminer dans la cavité de la couche de photorésist (6b). Le métal remplit les reliefs et la partie de la cavité (3) avec les parois obliques par effet de champignonnage, les parois de la cavité (3) étant isolées. Dans le cas d'une plaque (2) métallique, la couche conductrice (8b) devient superflue et l'isolation des parois de la cavité (3) usinée devient nécessaire. La pièce obtenue (9) comporte ainsi trois parties (9a, 9b, 9c) formées par les trois niveaux de la cavité mixte respectivement (7a), (3) et (7b).

Lorsque la plaque (2) assemblée sur le support conducteur (1) lors de l'étape A ou sur la couche de photorésist (6a) recouvrant ledit support conducteur (1) lors de l'étape A' est en matière conductrice, un dépôt d'une couche de matière isolante peut être effectué sur les parois internes structurées des cavités (3) traversantes. Ces parois structurés comportent un filetage ou une combinaison d'au moins un palier horizontal avec un filetage ou une combinaison d'au moins un flanc vertical ou oblique avec un filetage. La cavité mixte multi-niveaux de la figure 3 comprend deux cavités (3a, 3b) usinés dans deux plaques (2a, 2b) métalliques superposées et trois cavités (7a, 7b, 7c) formés dans des couches successives de photorésist (6a, 6b, 6c). Les parois des cavités usinées dans les plaques (2a, 2b) sont recouvertes d'une couche d'un matériau isolant (11 a, 11 b) assurant une croissance verticale de la couche métallique lors de l'électroformage à partir du support (1). La couche métallique pénètre ainsi par débordements dans la structure des parois internes des cavités (3a, 3b) usinées traversantes. Les paliers horizontaux (12a) et (12b) au fond du second et du troisième niveau de la cavité mixte restent conducteurs afin d'assurer la continuité de la croissance de la couche métallique.

Par contre, les paliers horizontaux des cavités en photorésist (7b) et (7c) ne sont pas nécessairement rendus conducteurs par dépôt d'une couche conductrice. En effet, la couche métallique peut déborder par champignonnage sur ces paliers horizontaux lorsque leur largeur n'est pas trop importante par rapport à l'épaisseur de la couche de photorésist.

Des essais ont montré que lorsque le rapport entre l'épaisseur de la couche de photorésist et la largeur du palier est plus grand ou égal à 1, la couche métallique croissant depuis le fond conducteur de la cavité peut déborder de manière à recouvrir le palier et croître uniformément le long de la paroi au-dessus du palier jusqu'au niveau du bord de la cavité formée dans la couche de photorésist.

Lorsque la plaque (2) assemblée sur le support conducteur (1) lors de l'étape A est en matière isolante, la disposition des cavités (7) formées dans la couche de photorésist (6) par rapport aux cavités (3) de la plaque (2) peut nécessiter un dépôt d'une couche conductrice (8) sur la surface de la plaque (2) effectué avant le dépôt de la couche de photorésist (6) lors de l'étape B. En particulier, ce dépôt d'une couche conductrice (8) est effectué lorsque le rapport entre l'épaisseur de la couche de photorésist (6) et la largeur des paliers formant le fond des cavités formées dans la couche de photorésist (6) est inférieur ou égal à 1.

Dans l'exemple de la figure 3, les rapports Hb/Lb et Hb/L'b entre l'épaisseur (Hb) de la couche de photorésist (6b) et la largeur des paliers (Lb) et (L'b) sont supérieurs à 1 ce qui implique que les paliers (Lb) et (L'b) formés par la face supérieure de la couche de photorésist (6a) peuvent être libres de couche conductrice. En ce qui concerne la cavité (7c) formée par la couche de photorésist (6c) déposée sur la couche (6b), la largeur du palier varie entre une petite et une grande valeur (Lc, L'c) par rapport à l'épaisseur (Hc) de la couche de photorésist (6c). Le rapport Hc/Lc entre l'épaisseur de la couche de photorésist (Hc) et la petite valeur de la largeur (Lc) est supérieur à 1 tandis que le rapport entre la même épaisseur (Hc) et la grande valeur de la largeur (L'c) est inférieur à 1. Dans ce cas, le dépôt d'une couche conductrice (8c) devient nécessaire au moins sur les portions du palier de grande largeur (L'c) par rapport à l'épaisseur de la couche de photorésist (Hc). A défaut de couche conductrice (8c) le débordement de la couche métallique peut seulement recouvrir le palier sans que sa croissance continue le long de la paroi de la cavité (7c) jusqu'à son bord supérieur.

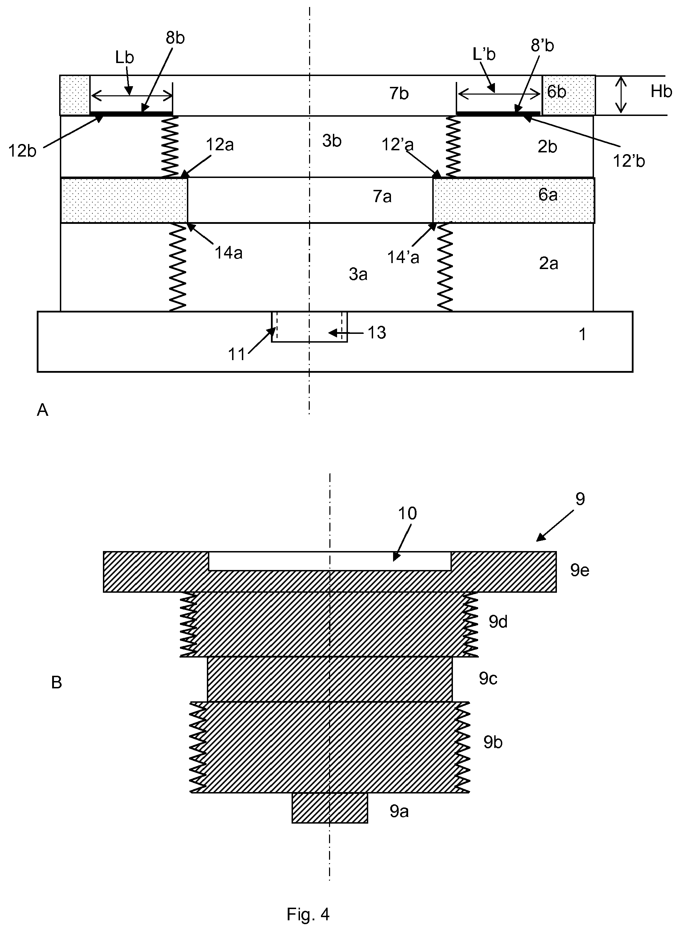

La figure 4A illustre une cavité mixte à cinq niveaux dont le premier niveau est formé par une cavité usinée (13) dans le support conducteur (1). Comme dans les cas d'utilisation de plaques usinées conductrices (cf. figure 3), la paroi de la cavité (13) est recouverte de matière isolante (11). Une première plaque isolante (2a) comportant au moins une cavité usinée (3a) traversante est assemblée sur le support (1) en disposant la cavité usinée (3a) au-dessus de la cavité (13) du support (1) pour former le second niveau. Un troisième niveau est ajouté par une couche de photorésist (6a) déposée sur la première plaque (2a) dans laquelle une cavité (7a) est formée par photolithographie au dessus de la cavité usinée (3a) du second niveau. Une seconde plaque isolante (2b) comportant au moins une cavité usinée (3b) traversante est assemblée sur la couche de photorésist (6a) au-dessus de la cavité (7a) du troisième niveau pour former le quatrième niveau. Finalement un cinquième niveau est formé par une cavité (7b) obtenue par photolithographie au-dessus de la cavité usinée (3b) du quatrième niveau. Une couche conductrice (8b, 8'b) est déposée sur le palier (12b, 12'b) car le rapport entre l'épaisseur (Hb) de la couche de photorésist (6b) et la largeur (Lb, L'b) du palier (12b, 12'b) est inférieur à 1.

D'une manière générale, les niveaux des cavités mixtes multi-niveaux sont disposés en V ou en pyramide inversée de manière à effectuer la croissance de la couche métallique dans des niveaux dont le périmètre du contour augmente globalement avec l'épaisseur de cette couche. Cette configuration s'applique indifféremment de la nature des niveaux, qu'ils soient usinés dans des plaques ou obtenus par photolithographie dans des couches de photorésist.

Selon un cas particulier illustré par la figure 4A, la couche de photorésist (6a) comporte une cavité (7a) dont le contour est entièrement inclus dans le contour de la cavité (3a) usinée dans la plaque isolante (2a) immédiatement inférieure. La différence de périmètre entre les contours des cavités (7a) et (3a) a une valeur déterminée de manière à permettre une croissance uniforme de la couche métallique le long des parois de la première plaque (2a) en passant par les parois de la couche de photorésist (6a) et de la seconde plaque (2b). Le rapport entre la largeur du palier (12a, 12'a) et l'épaisseur de la seconde plaque (2b) est dans ce cas supérieur à 1. De plus, la largeur des décrochements (14a) et (14'a) est déterminée de manière à permettre un remplissage complet de la cavité (3a) par la couche métallique. Par exemple, une largeur de décrochement équivalente à la largeur des décrochements formés sur la paroi de la cavité (3a) par l'usinage de la plaque (2a) satisfait la condition de remplissage complet de cette cavité (3a). En d'autres termes, le rapport entre l'épaisseur de la plaque isolante usinée (2a) immédiatement inférieure et la largeur du décrochement (14a, 14'a) est plus grand ou égal à 1.

La figure 4B montre la pièce micro mécanique monobloc obtenue par la croissance d'une couche métallique dans la cavité mixte de la figure 4A depuis le fond conducteur de la cavité (13) du support (1) jusqu'à la cavité (7b) du cinquième niveau formée dans la couche de photorésist (6b). La pièce comporte ainsi cinq parties (9a, 9b, 9c, 9d, 9e) issues des cinq niveaux de la cavité mixte. Un usinage final (10) peut être effectué dans la partie (9e) de la pièce après électroformage de celle-ci dans la cavité mixte.

Il est à noter que dans la réalisation des exemples des figures 1, 2, 3 et 4, les photomasques utilisés pour former les cavités dans les couches de photorésist couvrent complètement les cavités du niveau immédiatement inférieur.

Les pièces micro mécaniques ainsi obtenues à partir de cavités mixtes multi-niveaux comprennent une succession, dans un ordre prédéterminé, de parties métalliques superposées obtenues par électroformage dans un moule de photorésist et par électroformage dans une cavité usinée prolongeant le moule de photorésist. La couche métallique croît dans la cavité usinée le long d'une paroi comportant un filetage ou une combinaison d'au moins un palier horizontal avec un filetage ou une combinaison d'au moins un flanc vertical ou oblique avec un filetage.

Une pièce micro mécanique monobloc obtenue par le procédé de l'invention ne peut pas se distinguer à priori d'une pièce fabriquée par des procédés conventionnels d'usinage tels que le décolletage ou l'étampage. Par contre, la pièce peut être différenciée par observation au microscope de la structure cristalline du métal qui présente des caractéristiques propres au métal électroformé dans les niveaux successifs d'une cavité mixte, caractéristiques qui sont absentes de la structure d'un métal usiné.

Les micro-pièces comprennent en général au moins une partie usinée lors d'une étape postérieure à la croissance de la couche métallique monobloc.

## Revendications

1. Procédé de fabrication de micro-pièces métalliques comportant au moins deux parties dont au moins une partie étant obtenue par photolithographie et électroformage, cette méthode comprenant au moins les étapes suivantes:
A) assembler sur un support conducteur (1) au moins une plaque (2) en matière isolante ou conductrice comprenant une pluralité de cavités (3) traversantes, lesdites cavités (3) comportant une paroi interne (4) structurée comprenant un filetage ou une combinaison d'au moins un palier horizontal avec un filetage ou une combinaison d'au moins un flanc vertical ou oblique avec un filetage
B) déposer une couche de photorésist (6) sur la plaque (2), irradier et polymériser au moyen d'un photomasque (5), comportant une pluralité de motifs, de sorte que lesdits motifs couvrent entièrement chaque cavité (3) et au moins une zone dans le voisinage de chaque cavité (3) en contact avec ladite cavité (3), éliminer la couche de photorésist (6) non polymérisée de manière à obtenir une pluralité de cavités mixtes (3, 7), chaque cavité mixte (3, 7) comportant un premier niveau formé par la cavité (3) de la plaque (2) et un second niveau formé par une cavité (7) traversante dans la couche de photorésist (6), chaque cavité (7) du second niveau étant positionnée au-dessus de chaque cavité (3) du premier niveau de sorte que le périmètre de chaque cavité (7) du second niveau englobe le périmètre de chaque cavité (3) du premier niveau,
ou
B') déposer sur un support conducteur (1) une couche de photorésist (6a), irradier et polymériser la couche de photorésist (6a) au moyen d'un photomasque (5) et éliminer la couche de photorésist (6a) non polymérisée, la couche de photorésist restante formant une pluralité de cavités (7a) traversantes,
A') assembler sur le support conducteur (1) recouvert par la couche de photorésist (6a) au moins une plaque (2) en matière isolante ou conductrice comprenant une pluralité de cavités (3) traversantes, lesdites cavités (3) comportant un filetage ou une combinaison d'au moins un palier horizontal avec un filetage ou une combinaison d'au moins un flanc vertical ou oblique avec un filetage, de manière à obtenir une pluralité de cavités mixtes (7a, 3) comportant chacune un premier niveau formé par une cavité traversante (7a) dans la couche de photorésist (6a) et un second niveau formé par la cavité (3) traversante de la plaque (2), chaque cavité (3) du second niveau étant positionnée au-dessus de chaque cavité (7a) du premier niveau de sorte que le périmètre de chaque cavité (3) du second niveau englobe le périmètre de chaque cavité (7a) du premier niveau,
C) déposer une couche métallique (9a, 9b) par électroformage dans chaque cavité mixte (3, 7) de manière à remplir le premier et le second niveau,
D) usiner par un procédé mécanique la couche métallique (9a, 9b) à une épaisseur prédéfinie, éliminer le photorésist polymérisé,
E) extraire la couche métallique (9a, 9b) de chaque cavité (3) de la plaque (2) et du support conducteur (1) et obtenir une pluralité de micro-pièces (9) comportant deux parties superposées formées par les niveaux des cavités mixtes (3, 7).

2. Procédé selon la revendication 1 dans lequel la plaque (2) assemblée sur le support conducteur (1) lors de l'étape A est en matière isolante **caractérisé en ce que**, lorsque la largeur des paliers formant le fond des cavités formées dans la couche de photorésist (6) est plus grande ou égale à l'épaisseur de la couche de photorésist (6), un dépôt d'une couche conductrice (8) est effectué sur la surface de la plaque (2) avant le dépôt de la couche de photorésist (6) lors de l'étape B.

3. Procédé selon la revendication 1 dans lequel la plaque (2) assemblée sur le support conducteur (1) lors de l'étape A ou sur la couche de photorésist (6a) recouvrant ledit support conducteur (1) lors de l'étape A' est en matière conductrice **caractérisé en ce qu'**un dépôt d'une couche de matière isolante est effectué sur les parois internes (4) structurées des cavités (3) traversantes de la plaque (2), ladite couche de matière isolante assurant une croissance verticale de la couche métallique (9) lors de l'électroformage à partir du support conducteur (1) en pénétrant par débordements dans la structure des parois internes (4) des cavités (3) traversantes.

4. Procédé selon la revendication 1 dans lequel la plaque (2) assemblée sur la couche de photorésist (6a) recouvrant le support conducteur (1) lors de l'étape A' est en matière isolante **caractérisé en ce qu'**un dépôt d'une couche conductrice (8a) est effectué sur la couche de photorésist (6a) après l'obtention des cavités (7a) dans ladite couche de photorésist (6a) lors de l'étape B', ladite couche conductrice (8a) formant une base aux cavités (3) traversantes de la plaque (2).

5. Procédé selon l'une des revendications 1 à 4 **caractérisé en ce qu'**il comprend au moins une opération supplémentaire d'usinage de la couche métallique effectuée avant l'élimination du photorésist polymérisé et du support conducteur (1).

6. Procédé selon l'une des revendications 1 à 5 **caractérisé en ce qu'**il comprend une succession d'étapes supplémentaires dans un ordre prédéterminé de formation d'une pluralité de niveaux de cavités mixtes multi-niveaux par assemblage de plaques (2) en matière isolante ou conductrice comprenant une pluralité de cavités (3) traversantes usinées et par dépôt de couches de photorésist comprenant une pluralité de cavités obtenues par photolithographie, lesdits niveaux étant disposés de sorte que la couche métallique croisse dans des niveaux ayant un périmètre de contour qui augmente globalement avec l'épaisseur de ladite couche métallique, les micro-pièces obtenues comportant un nombre de parties correspondant au nombre de niveaux des cavités mixtes.

7. Procédé selon l'une des revendications 1 à 6 **caractérisé en ce qu'**il comprend une étape préalable d'usinage de cavités (13) dans le support conducteur (1) et une étape de dépôt d'une couche isolante (11) sur les parois internes des cavités (13).

## Patentansprüche

1. Herstellungsverfahren für Metallmikroteile mit mindestens zwei Teilen, von denen mindestens ein Teil durch Fotolithografie und Elektroformverfahren erhalten wird, wobei dieses Verfahren mindestens die folgenden Schritte umfasst:
A) Zusammenbauen, auf einem leitenden Träger (1), mindestens eine Platte (2) aus leitendem oder Isoliermaterial mit einer Vielzahl von Durchgangshohlräumen (3), wobei die Hohlräume (3) eine strukturierte Innenwand (4) umfassen, mit einem Gewinde oder einer Kombination von mindestens einem waagrechten Lager mit einem Gewinde oder einer Kombination von mindestens einer senkrechten oder schrägen Flanke mit einem Gewinde
B) Auftragung einer Fotoresistschicht (6) auf die Platte (2), Bestrahlung und Polymerisierung mittels einer Fotomaske (5) mit einer Vielzahl von Motiven, so dass die Motive jeden Hohlraum (3) ganz bedecken und mindestens einen Bereich in der Nähe jedes Hohlraums (3), der in Kontakt mit besagtem Hohlraum (3) steht, Entfernen der nicht polymerisierten Fotoresistschicht (6), um eine Vielzahl von gemischten Hohlräumen (3, 7) zu erhalten, wobei jeder gemischte Hohlraum (3, 7) eine erste Ebene aufweist, gebildet durch den Hohlraum (3) der Platte (2), und eine zweite Ebene, gebildet durch einen Durchgangshohlraum (7) in der Fotoresistschicht (6), wobei jeder Hohlraum (7) der zweiten Ebene über jedem Hohlraum (3) der ersten Ebene positioniert ist, so dass der Umfang jedes Hohlraums (7) der zweiten Ebene den Umfang jedes Hohlraums (3) der ersten Ebene miteinschließt,
oder
B') Auftragung, auf einen leitenden Träger (1), einer Fotoresistschicht (6a), Bestrahlung und Polymerisierung der Fotoresistschicht (6a) mittels einer Fotomaske (5) und Entfernen der nicht polymerisierten Fotoresistschicht (6a), wobei die übrige Fotoresistschicht eine Vielzahl von Durchgangshohlräumen (7a) bildet,
A') Zusammenbauen, auf dem leitenden Träger (1), der von der Fotoresistschicht (6a) bedeckt ist, mindestens einer Platte (2) aus leitendem oder Isoliermaterial mit einer Vielzahl von Durchgangshohlräumen (3), wobei die Hohlräume (3) ein Gewinde umfassen oder eine Kombination von mindestens einem waagrechten Lager mit einem Gewinde oder eine Kombination von mindestens einer senkrechten oder schrägen Flanke mit einem Gewinde, um eine Vielzahl von gemischten Hohlräumen (7a, 3) zu erhalten, die jeweils eine erste Ebene umfassen, gebildet durch einen Durchgangshohlraum (7a) in der Fotoresistschicht (6a), und eine zweite Ebene, gebildet durch den Durchgangshohlraum (3) der Platte (2), wobei jeder Hohlraum (3) der zweiten Ebene über jedem Hohlraum (7a) der ersten Ebene positioniert ist, so dass der Umfang jedes Hohlraums (3) der zweiten Ebene den Umfang jedes Hohlraums (7a) der ersten Ebene miteinschließt,
C) Auftragung einer Metallschicht (9a, 9b) durch Elektroformverfahren in jedem gemischten Hohlraum (3, 7), um die erste und die zweite Ebene zu füllen,
D) Bearbeiten der Metallschicht (9a, 9b) durch ein mechanisches Verfahren bis auf eine vorherbestimmte Dicke, Entfernen der polymerisierten Fotoresistschicht,
E) Extrahieren der Metallschicht (9a, 9b) aus jedem Hohlraum (3) der Platte (2) und des leitenden Trägers (1) und Erhalt einer Vielzahl von Mikroteilen (9) mit zwei überlagerten Teilen, gebildet durch die Ebenen der gemischte Hohlräume (3, 7).

2. Verfahren nach Anspruch 1, bei dem die im Schritt A auf dem leitenden Träger (1) zusammengebaute Platte (2) aus Isoliermaterial besteht, **gekennzeichnet dadurch, dass**, wenn die Breite der Lager die den Boden der Hohlräume in der Fotoresistschicht (6) bilden, größer oder gleich der Dicke der Fotoresistschicht (6) ist, das Aufbringen einer leitenden Schicht (8) auf der Oberfläche der Platte (2) vor dem Aufbringen der Fotoresistschicht (6) im Schritt B durchgeführt wird.

3. Verfahren nach Anspruch 1, bei dem die Platte (2), die im Schritt A auf dem leitenden Träger (1) oder auf der Fotoresistschicht (6a) zusammengebaut wird, die den leitenden Träger (1) im Schritt A' bedeckt, aus leitendem Material ist, **gekennzeichnet dadurch, dass** das Aufbringen einer Schicht Isoliermaterial auf die strukturierten Innenwände (4) der Durchgangshohlräume (3) der Platte (2) durchgeführt wird, wobei die Schicht Isoliermaterial ein senkrechtes Wachstum der Metallschicht (9) im Elektroformverfahren sichert, ausgehend von dem leitenden Träger (1) durch Eindringen durch Überlaufen in die Struktur der Innenwände (4) der Durchgangshohlräume (3).

4. Verfahren nach Anspruch 1, bei dem die auf der Fotoresistschicht (6a), die den leitenden Träger (1) im Schritt A' bedeckt, zusammengebaute Platte (2) aus Isoliermaterial ist, **gekennzeichnet dadurch, dass** das Aufbringen einer leitenden Schicht (8a) auf die Fotoresistschicht (6a) nach dem Erhalt der Hohlräume (7a) in der Fotoresistschicht (6a) im Schritt B' durchgeführt wird, wobei die leitende Schicht (8a) eine Basis für die Durchgangshohlräume (3) der Platte (2) bildet.

5. Verfahren nach einem der Ansprüche 1 bis 4, **gekennzeichnet dadurch, dass** es mindestens eine zusätzliche Bearbeitung der Metallschicht vor der Entfernung der polymerisierten Fotoresistschicht und des leitenden Trägers (1) umfasst.

6. Verfahren nach einem der Ansprüche 1 bis 5, **gekennzeichnet dadurch, dass** es eine Reihe von zusätzlichen Schritten in einer vorgegebene Reihenfolge der Bildung einer Vielzahl von Ebenen von gemischten Mehrebenen-Hohlräumen durch Zusammenbau von Platten (2) aus leitendem oder Isoliermaterial umfasst, mit einer Vielzahl von bearbeiteten Durchgangshohlräumen (3) und durch Aufbringung von Fotoresistschichten mit einer Vielzahl von durch Fotolithografie erhaltenen Hohlräumen, wobei die Ebenen so angeordnet sind, dass die Metallschicht in Ebenen wächst, mit einem Umfang mit einer Begrenzung, die insgesamt mit der Dicke der Metallschicht zunimmt, wobei die erhaltenen Mikroteile eine Zahl von Teilen aufweisen, die der Zahl der Ebenen der gemischten Hohlräume entspricht.

7. Verfahren nach einem der Ansprüche 1 bis 6, **gekennzeichnet dadurch, dass** es ein vorhergehender Bearbeitungsschritt von Hohlräumen (13) in dem leitenden Träger (1) umfasst und ein Schritt des Aufbringens einer Isolierschicht (11) auf die Innenwände der Hohlräume (13).

## Claims

1. Method for producing metallic micro-pieces including at least two parts of which at least one part being obtained by photolithography and electroforming, this method comprising at least the following steps:
A) assembling on a conductive support (1) at least one plate (2) made of insulating or conductive material comprising a plurality of through cavities (3), said cavities (3) including a structured inner wall (4) comprising a thread or a combination of at least one horizontal bearing with a thread or a combination of at least one vertical or oblique side with a thread
B) depositing a photoresist layer (6) on the plate (2), irradiating and polymerizing by means of a photo mask (5), including a plurality of patterns, so that said patterns entirely cover each cavity (3) and at least one area in the proximity of each cavity (3) in contact with said cavity (3), eliminating the non-polymerized photoresist layer (6) in order to obtain a plurality of mixed cavities (3, 7), each mixed cavity (3, 7) including a first level formed by the cavity (3) of the plate (2) and a second level formed by a through cavity (7) in the photoresist layer (6), each cavity (7) of the second level being positioned above each cavity (3) of the first level so that the perimeter of each cavity (7) of the second level includes the perimeter of each cavity (3) of the first level,
or
B') depositing a photoresist layer (6a) on a conductive support (1), irradiating and polymerizing the photoresist layer (6a) by means of a photo mask (5) and eliminating the non-polymerized photoresist layer (6a), the remaining photoresist layer forming a plurality of through cavities (7a),
A') assembling on the conductive support (1) covered by the photoresist layer (6a) at least one plate (2) made of insulating or conductive material comprising a plurality of through cavities (3), said cavities (3) including a thread or a combination of at least one horizontal bearing with a thread or a combination of at least one vertical or oblique side with a thread, in order to obtain a plurality of mixed cavities (7a, 3) each of them including a first level formed by a through cavity (7a) in the photoresist layer (6a) and a second level formed by the through cavity (3) of the plate (2), each cavity (3) of the second level being positioned above each cavity (7a) of the first level so that the perimeter of each cavity (3) of the second level includes the perimeter of each cavity (7a) of the first level,
C) depositing a metallic layer (9a, 9b) by electroforming in each mixed cavity (3, 7) in order to fill the first and the second levels,
D) machining the metallic layer (9a, 9b) to a predefined thickness by a mechanic process, eliminating the polymerized photoresist,
E) extracting the metallic layer (9a, 9b) of each cavity (3) of the plate (2) and of the conductor support (1) and obtaining a plurality of micro-pieces (9) including two superposed parts formed by the levels of the mixed cavities (3, 7).

2. Method according to claim 1 in which the plate (2) assembled on the conductive support (1) during step A is made of insulating material **characterized in that**, when the width of the bearings forming the bottom of the cavities formed in the photoresist layer (6) is greater than or equal to the thickness of the photoresist layer (6), a deposit of a conductive layer (8) is made on the surface of the plate (2) before the deposit of the photoresist layer (6) during step B.

3. Method according to claim 1 in which the plate (2) assembled on the conductive support (1) during step A or on the photoresist layer (6a) covering said conductive support (1) during step A' is made of conductive material **characterized in that** a deposit of an insulating material layer is made on the structured inner walls (4) of the through cavities (3) of the plate (2), said insulating material layer ensuring a vertical growth of the metallic layer (9) during the electroforming from the conductive support (1) penetrating by overflowing in the structure of the inner walls (4) of the through cavities (3).

4. Method according to claim 1 in which the plate (2) assembled on the photoresist layer (6a) covering the conductive support (1) during step A' is made of insulating material **characterized in that** a deposit of a conductive layer (8a) is made on the photoresist layer (6a) after obtaining the cavities (7a) in said photoresist layer (6a) during step B', said conductive layer (8a) forming a base to the through cavities (3) of the plate (2).

5. Method according to anyone of claims 1 to 4 **characterized in that** it includes at least one additional machining operation of the metallic layer carried out before the elimination of the polymerized photoresist and of the conductive support (1).

6. Method according to anyone of claims 1 to 5 **characterized in that** it includes a succession of additional steps in a predetermined order for forming a plurality of levels of multi-level mixed cavities by assembling plates (2) made of insulating or conductive material comprising a plurality of machined through cavities (3) and by depositing layers of photoresist comprising a plurality of cavities obtained by photolithography, said levels being arranged so that the metallic layer may grow in levels having an outline perimeter which increases globally with the thickness of said metallic layer, the micro-pieces obtained including a number of parts corresponding to the number of levels of the mixed cavities.

7. Method according to anyone of claims 1 to 6 **characterized in that** it includes a previous step of machining cavities (13) in the conductive support (1) and a step of depositing an insulating layer (11) on the inner walls of the cavities (13).
